# EUROPEAN PATENT APPLICATION

(11) **EP 4 733 248 A1**
(43) Date of publication of application: **29.04.2026**
(21) Application number: 24208621.3
(22) Date of filing: 24.10.2024
(51) Int. Cl.: B81B 3/00, B81C 1/00, G01P 15/125

(54) **MEMS DEVICE WITH RECESSED COMBS**

(71) Applicant: Murata Manufacturing Co., Ltd., Nagaokakyo-shi, Kyoto 617-8555 (JP)
(72) Inventor: KILPINEN, Petteri, 02620 Espoo (FI); LIUKKU, Matti, 00320 Helsinki (FI)
(74) Representative: Boco IP Oy Ab

(57) **Abstract**

A microelectromechanical device comprising with a device layer and first and second comb structures. The bottom of the first comb structure has a z-coordinate which is greater than both the z-coordinate of the bottom face of the device layer and the z-coordinate of the bottom of the second comb structure. The top of the second comb structure has a z-coordinate which is smaller than both the z-coordinate of the top face of the device layer and the z-coordinate of the top of the first comb structure. The device layer also comprises a cavity which extends from the bottom face of the device layer to the bottom of the second comb structure.

## Description

### FIELD OF THE DISCLOSURE

The present disclosure relates to microelectromechanical (MEMS) devices, and more particularly to comb structures which can be used in such devices. The present disclosure further concerns the geometry of such comb structures.

### BACKGROUND OF THE DISCLOSURE

MEMS devices often comprise (1) a fixed structure and (2) a mobile structure which is configured to move in relation to the fixed structure when an external force moves the device. The movement experienced by the entire MEMS device can be calculated by measuring the movement of the mobile structure inside the device.

The movement of the mobile structure may for example be measured with a capacitive transducer. This transducer may comprise one set of comb fingers on the fixed structure and another set of comb fingers on the mobile structure. These sets of comb fingers may be interdigitated with each other. When the mobile structure moves, the capacitance changes, and this change can be measured. Capacitive transducers may also in some MEMS devices be used as actuators which generate a force which moves the mobile structure.

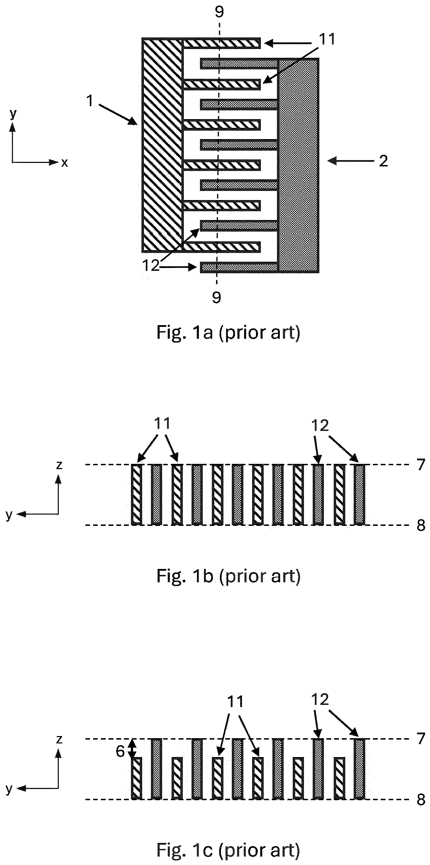

Figure 1a illustrates a device with a fixed structure 1 and a mobile structure 2. The fixed structure 1 comprises comb fingers 11 and the mobile structure 2 comprises comb fingers 12. The MEMS device typically comprises a device layer where both the fixed structure 1 and the mobile structure 2 are formed. This device layer may define an xy-plane.

It is well-known that the capacitive transducer shown in figure 1a can be used to measure the movement of the mobile structure 2 in the x-direction and in the y-direction. It can also, with some limitations, be used to measure the movement of the mobile structure 2 in the z-direction.

Figure 1b illustrates an yz-cross section of the capacitive transducer in figure 1a along the line 9-9. Reference numbers 7 and 8 indicate schematically the levels (z-coordinates) of the top (7) and bottom (8) faces of the device wafer where the comb fingers have been formed. It can be seen that all comb fingers 11 and 12 have the same height in the z-direction.

The comb arrangement illustrated in figure 1b can be used to measure how much the mobile structure moves in the z-direction (since such movement changes the overlap between combs 11 and 12), but it cannot be used to distinguish movement in the positive z-direction from movement in the negative z-direction.

Figure 1c illustrates an alternative configuration where fixed comb fingers 11 have been recessed to a recess depth 6 from the level 7. With the arrangement shown in figure 1c, movement of the mobile structure 2 (and the associated comb fingers 12) in the positive z-direction is not confused with movement in the negative z-direction. This is because the former movement decreases the capacitance between 11 and 12 (due to decreasing overlap), while the latter keeps the capacitance substantially unchanged.

However, the arrangement shown in figure 1c has its limitations. If the movement of the mobile structure 2 in the negative z-direction also needs to be measured, then a new set of interdigitated comb fingers with a different recess geometry would be needed for that purpose.

Furthermore, if a comb capacitor like the one in figures 1a and 1c is used to actuate a displacement of the mobile structure 2 in the z-direction, it can only achieve a very small displacement.

### BRIEF DESCRIPTION OF THE DISCLOSURE

An object of the present disclosure is to provide a method and an apparatus which overcomes the above disadvantages.

The object of the disclosure is achieved by a method and an arrangement which are characterized by what is stated in the independent claim[s]. The preferred embodiments of the disclosure are disclosed in the dependent claims.

The disclosure is based on the idea of utilizing comb structures that are recessed from both the top and bottom faces of the device wafer. The advantages this arrangement is that it allows a single set of comb structures to measure movement in both directions, and it also allows a large displacement in the z-direction to be actuated.

### BRIEF DESCRIPTION OF THE DRAWINGS

In the following the disclosure will be described in greater detail by means of preferred embodiments with reference to the accompanying drawings, in which
Figures 1a - 1c illustrate comb structures known from the prior art.
Figure 2a - 2d illustrate a microelectromechanical device.
Figure 3a - 3g illustrates a method for manufacturing a microelectromechanical device.
Figures 4a - 4d illustrate an alternative method.
Figures 5a - 5c also illustrate an alternative method.

### DETAILED DESCRIPTION OF THE DISCLOSURE

This disclosure describes a microelectromechanical (MEMS) device which comprises micromechanical structures formed in a device layer. The device layer defines a device plane, which is illustrated and referred to as the xy-plane. A z-axis is perpendicular to the xy-plane.

The device layer may be made of silicon. The device layer may for example be formed in a silicon wafer, which may be called a device wafer or structure wafer. Alternatively, the device layer may be a silicon layer which has been deposited on a substrate. In either case, the mobile and fixed microelectromechanical parts (for example mass elements, combs formed on the mass elements, and combs formed on fixed parts) may be formed in the device layer by etching.

The device layer may be structurally supported by a separate, thicker support wafer or substrate during manufacturing and/or in the finished accelerometer. The support wafer may also be called a handle wafer.

The MEMS device described in this disclosure comprises a fixed comb structure and a mobile comb structure. Each comb structure may comprise multiple finger-shaped structures. The word "finger-shaped" refers here to a structure which has a high length / width aspect ratio in the xy-plane. This aspect ratio may for example greater than 5, or greater than 10. A set of finger-shaped structures, comprising at least two structures, may together form a comb structure. The finger-shaped structures which form a comb structure may be parallel to each other in the xy-plane, but do not necessarily all have to be parallel.

The mobile comb structure may be formed on a mass element which is suspended from an adjacent fixed structure with flexible suspenders. The fixed comb structure may be formed on an adjacent fixed structure. The mobile comb structure may be interdigitated with the fixed comb structure so that each fixed finger-shaped structure (except, possibly, the ones at the end of the comb) is flanked by two mobile finger-shaped structures, and vice versa.

This disclosure describes a microelectromechanical device comprising
- a device layer with a top face and a bottom face, wherein the device layer defines an xy-plane and a z-coordinate which is perpendicular to the xy-plane, and the top face of the device layer has a greater z-coordinate than the bottom face,
- a handle wafer, wherein the bottom face of the device layer is attached to the handle wafer, and
- a first comb structure and a second comb structure in the device layer, wherein each first and second comb structure has a top and a bottom, and the first comb structure is interdigitated with the second comb structure.

The bottom of the first comb structure has a z-coordinate which is greater than both the z-coordinate of the bottom face of the device layer and the z-coordinate of the bottom of the second comb structure.

The top of the second comb structure has a z-coordinate which is smaller than both the z-coordinate of the top face of the device layer and the z-coordinate of the top of the first comb structure.

The device layer comprises a cavity which extends from the bottom face of the device layer to the bottom of the second comb structure.

Throughout this disclosure, terms such as "top" and "bottom", "above" and "below" refer only to relative positions in relation to the z-direction which is perpendicular to the device plane. They do not imply anything about how the device should be orientated during manufacturing or use.

Throughout this disclosure, the term "fixed" refers to device parts that do not move in relation to the handle wafer when the MEMS device is used. The word "mobile", on the other hand, refers to device parts that may move in relation to the handle wafer when the MEMS device is used.

The first and second comb structure may form a capacitive transducer. In any embodiment presented in this disclosure, the first comb structure may be a fixed comb structure and the second comb structure may be a mobile comb structure. Alternatively, the second comb structure may be a fixed comb structure and the first comb structure may be a mobile comb structure.

In other words, the device layer may comprise a fixed part and a mobile part. The fixed part may be immobile in relation to the handle wafer, and the mobile part may be mobile in relation to the fixed part. The fixed part may comprise the first comb structure, and the mobile part may comprise the second comb structure. Alternatively, the fixed part may comprise the second comb structure and the mobile part may comprise the first comb structure.

The mobile part may be a mass element where the mobile comb structure has been formed. The relative positions of the fixed parts and mobile parts which are described in this disclosure may refer to a situation where the mobile part is in its rest position. If the MEMS device is an accelerometer, the mobile part may be in its rest position when the device does not experience acceleration. If the MEMS device is a gyroscope, the mobile part may be in its rest position when it is not being driven in primary oscillation motion. The mobile comb structure may, but does not necessarily have, be located near the edge of the mobile part. The displacement experienced by the mobile part may be maximal at this edge.

The mobile part may be configured to be mobile in the z-direction. In practice, this means that the mobile part may be suspended from the fixed part with a flexible suspension arrangement which allows the mobile part to move in the z-direction in relation to the fixed part. This movement may be rotational out-of-plane movement about an axis which lies in the device plane, or it may be linear out-of-plane movement, or a mixture of linear and rotational out-of-plane movement.

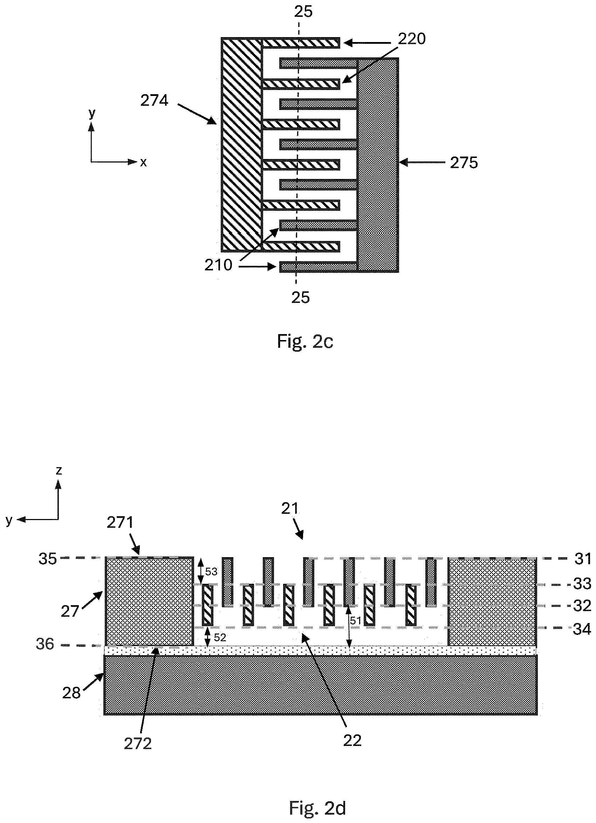

However, the z-direction is not necessarily the only direction in which the mobile part is allowed to move. The mobile part may also be configured to be mobile in the xy-plane, for example in the y-direction. The first and second comb structures may extend in the x-direction in the xy-plane, as figure 2c illustrates. The mobile part may also be configured to be mobile in the x-direction.

The MEMS device may comprise a control unit which is electrically coupled to the capacitive force transducer. The control unit may be configured to retrieve a measurement signal from the capacitive transducer, and or to transmit a control signal to the transducer.

The MEMS device may be an accelerometer or a gyroscope.

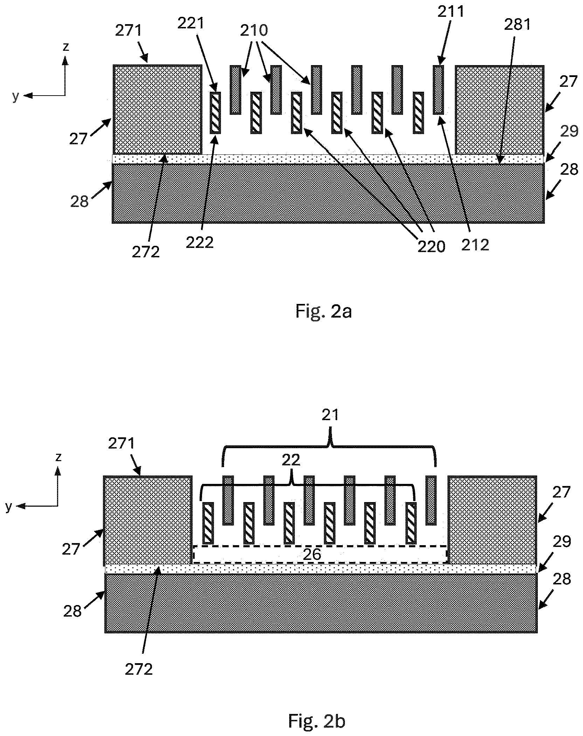

Figures 2a and 2b illustrate a MEMS device with a device layer 27 and a handle wafer 28. The device layer is shown as a very thick layer for illustrative purposes. In practice, the thickness of the device layer in the z-direction may for example be 50 - 100 micrometers, while the handle wafer may be of millimeter thickness. The device layer 27 is attached to the handle wafer 28 with an insulating layer 29. The three layers 27, 28, 29 may together form a silicon-on-insulator (SOI) wafer.

The device layer 27 has a top face 271 and a bottom face 272. The handle wafer 28 has a top face 281. The bottom of the device layer 27 is bonded to the top face 281 of the device layer. The top face 281 of the handle wafer 28 may be substantially flat. In other words, it may be parallel to the xy-plane and there may be no cavity in the handle wafer.

The MEMS device comprises a first comb structure 21 and a second comb structure 22, illustrated in figure 2b. The first comb structure 21 comprises a set of first finger-shaped structures 210, while the second comb structure 22 comprises a set of second finger-shaped structures 220, as figure 2a illustrates.

Figures 2a - 2b illustrate yz-cross-sections of finger-shaped structures 210 and 220. These structures may extend in the x-direction and be supported by neighbouring structures 274 and 275, as figure 2c illustrates. One of the structures 274-275 may be a fixed structure in the device layer, while the other may a mobile structure in the device layer. Figures 2a - 2b may be yz-cross-section of the structure in figure 2c along the line 25-25. However, many other geometries can also be utilized in the xy-plane to create two interdigitated comb structures in the device layer.

The first and second comb structures may form a capacitive transducer. When the mobile structure moves, the capacitance changes, and this change can be measured. Alternatively or additionally, the capacitive transducer may be used as an actuator which generates a force which moves the mobile structure.

The first comb structure 21 has a top side 211 and a bottom side 212, as figure 2a illustrates. The tops of all parts of the first comb structure 21, including the first finger-shaped structures 210, may be aligned at a first z-coordinate 31, illustrated in figure 2d, which is the z-coordinate of the top side 211 of the first comb structure 21. Alternatively, the tops of all parts of the first comb structure 21 may not have the same z-coordinate. In that case, the z-coordinate of the top side of the first comb structure may be the z-coordinate of the part of the first comb structure which has the highest z-coordinate. In any case, the coordinates of the tops of all parts of the first comb structure 21 are greater than the z-coordinate of the top 221 of the second comb structure 22.

The bottoms of all parts in the first comb structure 21 may be aligned at a second z-coordinate 32, which is the z-coordinate of the bottom side 212 of the first comb structure 21. Alternatively, the bottoms of all parts of the first comb structure 21 may not have the same z-coordinate. In that case, the z-coordinate of the bottom side 212 of the first comb structure may be the z-coordinate of the part of the first comb structure 21 which has the smallest z-coordinate. In any case, the coordinates of the bottoms of all parts of the first comb structure 21 are less than the z-coordinate of the top 221 of the second comb structure 22 and greater than the z-coordinate of the bottom 222 of the second comb structure 22.

The second comb structure 22 also has a top side 221 and a bottom side 222. The tops of all parts of the second comb structure 22, including the second finger-shaped structures 220, may be aligned at a third z-coordinate 33, as figure 2d illustrates. This is the z-coordinate of the top side 221 of the second comb structure 22. The bottoms of all parts in the second comb structure 22 may be aligned at a fourth z-coordinate 34, which is the z-coordinate of the bottom side 222 of the first comb structure 21.

Alternatively, the z-coordinate of the top side 221 and bottom side 222 may be set by the highest and the lowest parts of the second comb structure 22, as explained above for the first comb structure 21. In any case, the coordinates of the tops of all parts of the second comb structure 22 are greater than the z-coordinate of the bottom 222 of the first comb structure 21 and less than the z-coordinate of the top 211 of the first comb structure 221. The coordinates of the bottoms of all parts of the second comb structure 22, on the other hand, are always less than the z-coordinate of bottom 212 of the first comb structure 21.

As figure 2d shows, the bottom 212 of the first comb structure 21 has a z-coordinate 32 which is greater than both the z-coordinate 36 of the bottom face 272 of the device layer 272 and the z-coordinate 34 of the bottom 222 of the second comb structure 22. The top 221 of the second comb structure 22 has a z-coordinate 33 which is smaller than both the z-coordinate 35 of the top face 271 of the device layer 27 and the z-coordinate 31 of the top 211 of the first comb structure 21.

The z-coordinate 31 may be equal to the z-coordinate 35, as figure 2d illustrates. However, the top of the first comb structure could alternatively have a z-coordinate 31 which is less than the z-coordinate 35 of the top face 271 of the device layer 27.

The z-coordinate 34, on the other hand, is greater than the z-coordinate 36 of the bottom face 272 of the device layer 27.This is because, as figure 2b illustrates, the device layer 27 comprises a cavity 26 which extends from the bottom face 272 of the device layer 27 to the bottom 222 of the second comb structure 22.

In other words, there is an open space in the device layer between the second comb structure 22 and the handle wafer 28 (and the insulating layer 29 if it is present on the handle wafer 28). This open space may for example ensure that the moving structure in the device layer does not come into close proximity with the handle wafer.

Such proximity could cause unwanted electrical interaction or gas damping between the moving structure and the handle wafer. It is also possible to avoid proximity by forming an open space in the handle wafer 28 right beneath the comb structures. However, if this solution is used, then the handle wafer 28 must be very precisely aligned with the device layer 27 when they are attached to each other, so that the comb region lies precisely above the open space. With the arrangement shown in figures 2a - 2b and 2d, there is no need for such highly accurate alignment.

The first comb structure 21 is recessed to a first recess depth 51 from the bottom face 272 of the device layer 27. The first recess depth is equal to the difference between z-coordinates 32 and 36. As mentioned above, the first comb structure 21 may optionally be recessed also from the top face 271 of the device layer 27 (this has not been illustrated). The first recess depth 51 may for example be in the range 10- 50 micrometers, or in the range 25-40 micrometers.

The second comb structure 22 is recessed to a second recess depth 52 from the bottom face 272 of the device layer 27. The second comb structure 22 is recessed to a third recess depth 53 from the top face 272 of the device layer 27. It can be seen in figure 2d that the third recess depth 53 is equal to the difference between z-coordinates 31 and 33, while the second recess depth is equal to the difference between z-coordinates 34 and 36. The second recess depth 52 may for example be in the range 10 - 40 micrometers or in the range 15 - 25 micrometers. The third recess depth 53 may for example be in the range 5 - 20 micrometers or in the range 10 - 15 micrometers.

The thickness of the device layer 27 in the z-direction (i.e. the distance between lines 35 and 36) may for example be approximately 50 micrometers. The second recess depth 52 may be approximately 20 micrometres, and the difference between the first (51) and second (52) recess depths may be approximately 12.5 micrometres. The third recess depth 53 may also be approximately 12.5 micrometres. The height of the region where the first (21) and second (22) comb structures overlap, i.e. the distance between lines 32 and 33 in the z-direction, may then be approximately 5 micrometers.

The capacitive transducer formed by the first and second comb structures may be configured to measure the movement of the mobile device part in relation to the fixed structures of the device. If a displacement of the mobile part occurs in the x-direction or y-direction, the capacitance of the capacitor formed between 21 and 22 will change, and this change can be measured.

Displacement in the z-direction may now be discussed under the assumption that the first comb structure 21 is mobile, while the second comb structure 22 is fixed. When the mobile part (which comprises the first comb structure 21) is displaced upward, in the positive z-direction indicated in the figure, the capacitance will decrease due to decreasing overlap between 21 and 22. When the mobile part is displaced downward, in the negative z-direction, the capacitance will increase due to increasing overlap. The comb geometry and the flexible properties of the suspension of the mobile part may be configured so that comb structure 22 never moves below comb structure 21 in normal use. The capacitance of the capacitor between 21 and 22 will then be proportional to displacement in the z-direction both in upward movement and in downward movement. The same measurement principle applies also if comb structure 22 is mobile while 21 is fixed - only the direction in which capacitance increases and the direction in which it decreases are switched.

If the mobile part can be displaced in the z-direction as well as in the x- and/or the y-direction, then some additional arrangements can be made to ensure that each kind of movement can be reliably distinguished from the others. However, the z-axis measurement principle described above remains unchanged even with such arrangements.

Alternatively or additionally, the capacitive transducer may be configured to actuate a movement in a mobile device part, such as the mass element. This actuation may for example be a part of a self-test procedure where the mobile part is deliberately displaced by a known amount and the resulting measurement signal is checked. With the comb arrangement illustrated in figures 2a - 2d, the mobile part can be displaced until either the z-coordinates of the top sides 211 and 221 are equal or the z-coordinates of the bottom sides 212 and 222 are equal.

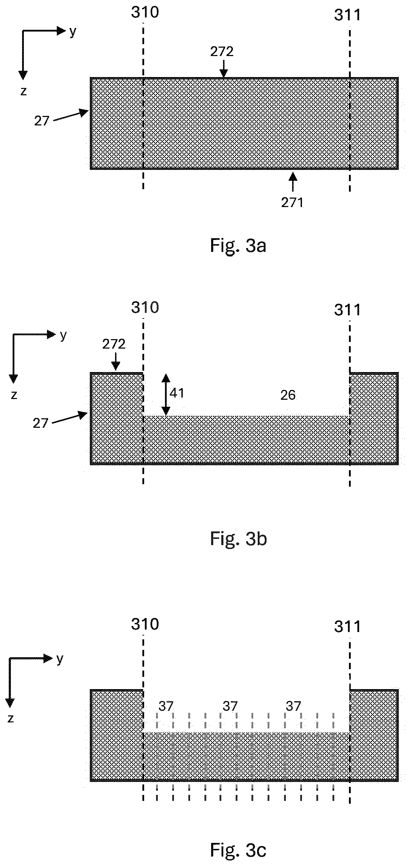

This disclosure also describes a method for manufacturing a microelectromechanical device. The method is illustrated in figures 3a - 3g. The method comprises providing a device layer 27. The device layer 27 comprises a top face 271 and a bottom face 272. The device layer 27 comprises a cavity region 310 - 311. The cavity region 310 - 311 comprises a set of first comb regions 37, a set of second comb regions 39 and a set of intermediate regions 38. Each first comb region 37 is separated from an adjacent second comb region 39 by one of the intermediate regions 37.

The method comprises etching the device layer 27 to a first etching depth 41 from the bottom face 272 in the cavity region 310 - 311 to form a cavity 26 in the cavity region. The method also comprises etching the device layer 27 to a second etching depth 42 from the bottom face 272 at least in the set of first comb regions 37, wherein the second etching depth is greater 42 than the first etching depth 41.

The method also comprises providing a handle wafer 28 and attaching the bottom face 272 of the device layer 27 to the handle wafer 28. The method also comprises etching through the device layer 27 from the top face 271 to the bottom face 272 in the one or more intermediate regions 38. The method also comprises etching the device layer 27 to a third etching depth 43 from the top face 271 in the set of second comb regions 39.

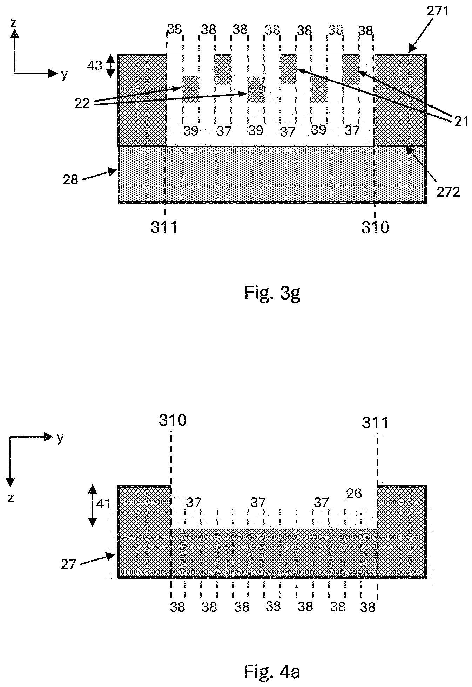

All details specified above about the device layer 27 and the handle wafer 28 apply also in this method. As figure 3g illustrates, the first comb regions 37 may be the regions where the first comb structure 21 is formed. The second comb regions 39 may be the regions where the second comb structure 22 is formed. The cavity region 310 - 311 is the region of the xy-plane where the cavity 26 is formed. The first and second comb regions 37 and 39 and intermediate regions 38 lie within the cavity region 310 - 311 in the xy-plane.

Figure 3a shows the device layer 27, which may be a silicon wafer. The device layer may define the xy-plane. In figure 3b, the device layer 27 has been patterned in an etching process to form the cavity 26 in the cavity region 310 - 311. This etching is performed to the first etching depth 41. The second recess depth 52 in figure 2d is equal to the first etching depth 41.

Any etching step described in this disclosure may be performed by depositing a suitable mask layer pattern on the face of the device layer, and in some cases also be depositing a protective layer on the vertical sidewalls of previously prepared trenches when new trenches are etched. The deposition and patterning of the mask layers and protective layers has not been separately illustrated.

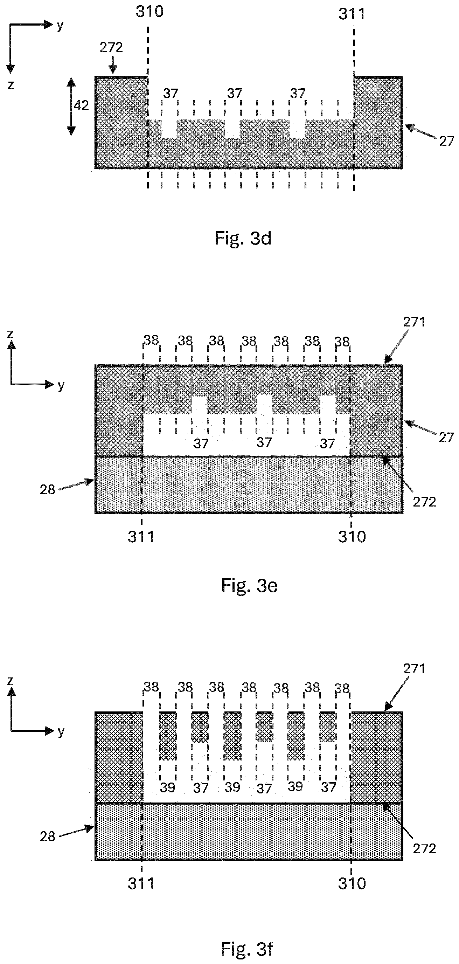

Figure 3c illustrates the locations of the first comb regions 37. Figure 3d shows the etching step where the device layer 27 is etched to a second etching depth. In this step the method may comprise forming first trenches on the bottom of the cavity 26 in the first comb regions 37. These first trenches extend to the second etching depth 42 in relation to the bottom face 272 of the device wafer 27. The first recess depth 51 in figure 2d is equal to the second etching depth 42.

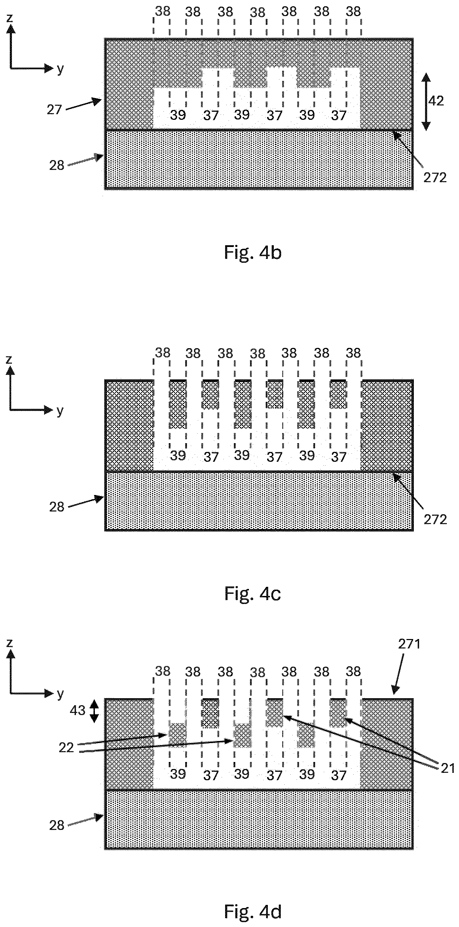

The etching step illustrated in figure 3d may for example be performed with DRIE etching. Optionally, some intermediate regions 38 may also be etched to the same second etching step 42 in this etching process. This will be discussed below with reference to figures 4a - 4d.

The device layer can be oriented in any direction when the steps illustrated in figures 3a - 3d are performed. The device layer is shown in an "upside down" position in these figures for illustrative purposes. The etching processes shown in figures 3b - 3d work in the direction of the z-axis, from the bottom face 272 toward the top face 271.

In figure 3e the z-axis points upward in the plane of the figure. The bottom face 272 of the device layer 27 is here attached to the handle wafer 28, for example with a layer of insulating material which is not illustrated. As mentioned previously, the device layer 27 does not necessarily have to be aligned with very high accuracy with the handle wafer, since the handle wafer 28 comprises just a flat surface without any microstructures.

The parts of the device layer 27 which lie in the intermediate regions 38 have been removed in figure 3f. In other words, an etching process which proceeds through the device layer 27 from the top face 271 to the bottom face 272 has been performed in the one or more intermediate regions 38. This etching step may be performed with DRIE etching.

The second comb regions 39 are illustrated in figure 3f. These regions are parts which remain in the device layer 27 after the intermediate regions 38 have been removed. The second combs regions 39 are then recessed from the top face 271 of the device layer in an etching step which is illustrated in figure 3g. This step may be performed in a DRIE etching process. The device layer 27 is here etched to a third etching depth 43, which corresponds to the third recess depth 53 in figure 2d. The first and second comb structures have thereby been prepared.

The first trenches formed from the bottom of the cavity 26 may alternatively be extended into all intermediate regions 38, or into some but not all intermediate regions 38. This is illustrated in figures 4a - 4d. Figure 4a shows the same structure as figure 3c. In figure 4b, which corresponds to figure 3e, it can be seen that the device layer 27 has also been recessed in some of the intermediate regions 38, but not all of them. Figures 4c - 4d illustrate the remaining steps of the method, which can be performed in the same manner as in figures 3f - 3g.

In other words, the step of etching the device layer 27 to a second etching depth 42 from the bottom face 272 at least in the set of first comb regions 37 may also comprise etching the device layer 27 to the second etching depth 42 in at least one of the one or more intermediate regions 38. On the other hand, regardless of whether or not at least one intermediate region 38 is etched in this step, at least one of the one or more intermediate regions 38 may not be etched to the second etching depth 42 in the step of etching the device layer 27 to the second etching depth 42 from the bottom face 272. Another alternative is that all the intermediate regions 38 are etched to the second etching depth in this step.

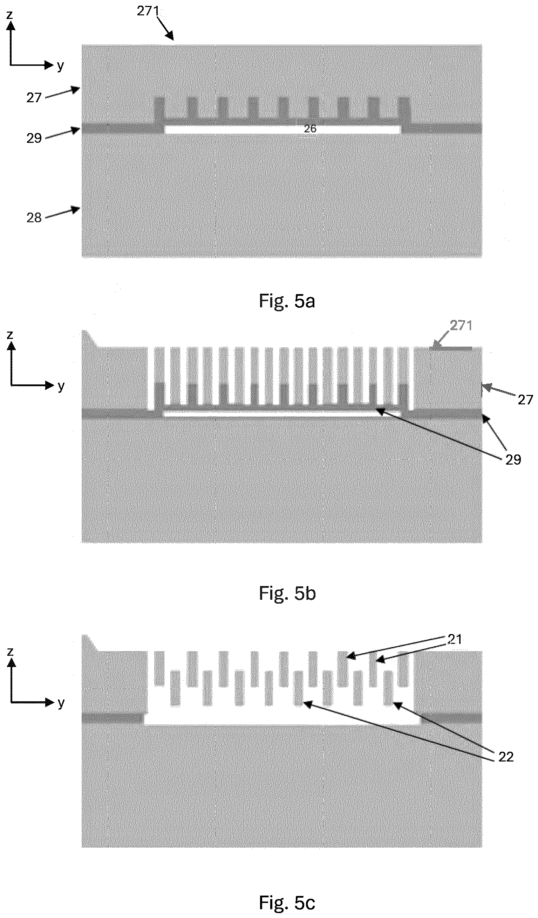

Figure 5a illustrates an alternative method. Here the insulating layer 29, which may be silicon dioxide layer, and which will attach the device layer 27 to the handle wafer 28, has been deposited onto the bottom face 272 of the device layer 27 in the stage which is illustrated in figure 3d. Figure 5b illustrates an etching step where the intermediate regions 38 are removed in an etching step which proceeds through the device layer 27 until it meets the insulating layer 29. The device layer 27 may then be etched to the third etching depth from the top face 271 in the set of second comb regions to form the recessing from the top face 271.

## Claims

1. A microelectromechanical device comprising:
- a device layer with a top face and a bottom face, wherein the device layer defines an xy-plane and a z-coordinate which is perpendicular to the xy-plane, and the top face of the device layer has a greater z-coordinate than the bottom face,
- a handle wafer, wherein the bottom face of the device layer is attached to the handle wafer,
- a first comb structure and a second comb structure in the device layer, wherein each first and second comb structure has a top and a bottom, and the first comb structure is interdigitated with the second comb structure,
**characterized in that**
- the bottom of the first comb structure has a z-coordinate which is greater than both the z-coordinate of the bottom face of the device layer and the z-coordinate of the bottom of the second comb structure, and
- the top of the second comb structure has a z-coordinate which is smaller than both the z-coordinate of the top face of the device layer and the z-coordinate of the top of the first comb structure, and
- the device layer comprises a cavity which extends from the bottom face of the device layer to the bottom of the second comb structure.

2. A microelectromechanical device according to claim 1, wherein
- the device layer comprises a fixed part and a mobile part, wherein the fixed part is immobile in relation to the handle wafer, and the mobile part is mobile in relation to the fixed part.

3. A microelectromechanical device according to claim 2, wherein the fixed part comprises the first comb structure and the mobile part comprises the second comb structure.

4. A microelectromechanical device according to claim 2, wherein the fixed part comprises the second comb structure and the mobile part comprises the first comb structure.

5. A microelectromechanical device according to any of claims 2-4, wherein the mobile part is configured to be mobile in the z-direction.

6. A microelectromechanical device according to claim 5, wherein the first and second comb structures extend in the x-direction in the xy-plane, and the mobile part is also configured to be mobile in the y-direction.

7. A microelectromechanical device according to any preceding claim, wherein the device layer is made of silicon.

8. A method for manufacturing a microelectromechanical device, comprising:
- providing a device layer, wherein the device layer comprises a top face and a bottom face, and the device layer comprises a cavity region, and the cavity region comprises a set of first comb regions, a set of second comb regions and a set of intermediate regions, wherein each first comb region is separated from an adjacent second comb region by one of the intermediate regions,
- etching the device layer to a first etching depth from the bottom face in the cavity region to form a cavity in the cavity region,
- etching the device layer to a second etching depth from the bottom face at least in the set of first comb regions, wherein the second etching depth is greater than the first etching depth,
- providing a handle wafer and attaching the bottom face of the device layer to the handle wafer,
- etching through the device layer from the top face to the bottom face in the one or more intermediate regions,
- etching the device layer to a third etching depth from the top face in the set of second comb regions.

9. A method according to claim 8, wherein the step of etching the device layer to the second etching depth from the bottom face at least in the set of first comb regions also comprises etching the device layer to the second etching depth in at least one of the one or more intermediate regions.

10. A method according to any of claims 8-9, wherein at least one of the one or more intermediate regions is not etched to the second etching depth in the step of etching the device layer to the second etching depth from the bottom face.
